(19) Europäisches Patentamt
European Patent Office
Office européen des brevets

(11) **EP 4 286 041 B1**

(12) **EUROPEAN PATENT SPECIFICATION**

(45) Date of publication and mention
of the grant of the patent:
**29.01.2025  Bulletin 2025/05**

(21) Application number: **22176394.9**

(22) Date of filing: **31.05.2022**

(51) International Patent Classification (IPC):
**B01J 19/00** *(2006.01)*     **G11C 13/00** *(2006.01)*

(52) Cooperative Patent Classification (CPC):
**B01J 19/0046;** B01J 2219/00317;
B01J 2219/00529; B01J 2219/00608;
B01J 2219/00621; B01J 2219/00653;
B01J 2219/00659; B01J 2219/00713;
B01J 2219/00722; G11C 8/00; G11C 13/0019;
G11C 13/0023

(54) **A MOLECULAR SYNTHESIS ARRAY**

MOLEKULARSYNTHESEANORDNUNG

RÉSEAU DE SYNTHÈSE MOLÉCULAIRE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**06.12.2023  Bulletin 2023/49**

(73) Proprietors:
  • **Imec VZW**
    **3001 Leuven (BE)**
  • **Katholieke Universiteit Leuven
    KU Leuven Research & Development
    3000 Leuven (BE)**

(72) Inventors:
  • **LOCKHART DE LA ROSA, Cesar Javier
    3150 Haacht (BE)**
  • **WILLEMS, Kherim
    3051 Sint-Joris-Weert (BE)**
  • **HENRY, Olivier
    1950 Kraainem (BE)**
  • **HOELZ, Kathrin
    3001 Leuven (BE)**

(74) Representative: **AWA Sweden AB
Box 5117
200 71 Malmö (SE)**

(56) References cited:
**WO-A1-2020/131354       WO-A2-02/31463
US-A1- 2005 095 637       US-A1- 2021 310 981**

EP 4 286 041 B1

**Description**

Technical field

The present inventive concept relates to a molecular synthesis array. The present inventive concept further relates to a molecular synthesis device, a data storage system comprising a molecular synthesis device and a method for enabling synthesis in a molecular synthesis device.

Background

DNA (deoxyribonucleic acid) chips provide a collection of nucleic acid strands immobilized at defined locations on a solid surface. DNA chips allow for high-throughput electrochemical synthesis of DNA and have become a core technology in the field of bio-analytics and bio-medical diagnostics. Lately, DNA microarrays have become a powerful tool beyond the traditional gene expression experiments in many other research areas, for instance for gene assembly, DNA origami or as a platform for data storage.

DNA chips may comprise arrays of electrodes providing electrochemically controlled *in situ* synthesis of different oligonucleotides at defined positions in the array. As advances in microfabrication technology enables scaling of the electrodes, it is envisaged that such arrays has the potential to allow for high density and high throughput DNA synthesis. Although reference in the above is made to arrays for DNA synthesis, this technology is not limited to synthesis of DNA, but may more generally be used for synthesis of organic molecules, such as polymers, DNA or ribonucleic acid (RNA).

Up to know, microarrays for molecular synthesis typically rely on a structure where every electrode (and thus every synthesis location) is addressed one-by-one. While this may facilitate selective addressing of the synthesis locations, it makes scaling more challenging as the increased number or electrodes complicates the routing of the electrodes, and also as the area needed for routing will limit the density of electrodes. This may in effect limit the density of synthesis locations which may be achieved in the array. WO2020/131354 discloses a substrate suitable for synthesis of polynucleotides.

Summary

In view of the above, it would be desirable to provide a molecular synthesis array enabling a relatively large number of synthesis locations in a relatively small area (i.e. a high density of synthesis locations), e.g. in order to facilitate storage of large amount of data in the array. At the same time, it would be desirable to enable selective addressing of the individual synthesis locations, to provide individual control over the synthesis reaction at each synthesis location (i.e. to avoid activating neighboring synthesis locations). It is an object of the present inventive concept to address these needs. Further and alternative objectives may be understood from the following.

According to a first aspect of the present inventive concept there is provided a molecular synthesis array. The molecular synthesis array comprises: a substrate; an insulating layer arranged on the substrate; a plurality of lower electrode lines extending in parallel along a column direction of the molecular synthesis array, and a plurality of upper electrode lines extending in parallel along a row direction of the molecular synthesis array, wherein the upper electrode lines are vertically separated from the lower electrode lines and extend across the lower electrode lines, and wherein the lower and upper electrode lines are embedded in the insulating layer; and a plurality of synthesis wells, wherein each well is formed at a crossing between a lower electrode line and an upper electrode line and extends from an upper surface of the insulating layer to the lower electrode line, through the insulating layer and through the upper electrode line, and exposes an electrode surface portion of the upper electrode line and an electrode surface portion of the lower electrode line.

The inventive molecular synthesis array of the first aspect may enable a number of advantages:

   (i) increasing the feasibility of area efficient synthesis arrays with a large numbers of synthesis locations,
   (ii) the well structure of the synthesis locations reduces the risk of crosstalk between neighboring synthesis wells,
   (iii) less complexity during fabrication as the need for an external selector device (e.g. a transistor) or a capacitor (as the potential in the synthesis well itself can be utilized instead) is mitigated, and
   (iv) the number of electrode connections needed scales proportional to the square root of the number of electrodes instead of scaling proportional to the number of electrodes as in an array wherein each electrode (and thus every synthesis location) is addressed one-by-one.

These advantages may be better and more fully understood from the following.

According to the molecular synthesis array, an array of synthesis wells may be defined, wherein each synthesis well may define a respective synthesis location (i.e. a synthesis spot or a synthesis cell), i.e. a location in the array where a molecular synthesis reaction may be enabled by electrical activation of the electrode lines crossing at the synthesis well.

More specifically, the molecular synthesis array and the synthesis wells thereof may, in use, be supplied with a molecular synthesis medium, for instance a liquid solution including reagents for a synthesis reaction.

The electrode surfaces of the upper and lower electrode lines exposed at each synthesis well may be configured to control a reaction condition at the respective synthesis wells. The electrode surfaces at each synthesis well may be configured to, in response to being activated, enable or inhibit a chemical reaction in the molecular synthesis medium. The molecular synthesis medium of each synthesis well (and any reagents supplied to the synthesis wells) may be such that a chemical reaction will be inhibited (i.e. will not occur) unless the associated electrode is activated. Alternatively, the molecular synthesis medium of each synthesis well may be such that a chemical reaction will be enabled (i.e. will occur) unless the associated electrode is activated. In other words, an electrode may, depending on the particular type of synthesis, either be configured to enable the reaction or inhibit the reaction when being activated.

By "activating" or "biasing" an electrode is hereby meant supplying the electrode with a current or voltage via the lower electrode line and/or the upper electrode line. The voltage may be of such a magnitude that the chemical reaction is enabled or inhibited, as the case may be.

The crossing arrangement of lower and upper electrode lines enables what may be referred to as a "cross bar structure", wherein a specific electrode and synthesis location can be addressed by biasing a lower electrode (column) line (e.g. corresponding to a working electrode - WE) and an upper electrode (row) line (e.g. corresponding to a counter electrode - CE) instead of addressing each of the electrodes individually. This can conceptually be compared to addressing of bit cells in traditional crossbar solid-state memory cells (equivalent to the electrode surfaces at the synthesis wells) by biasing word lines and bit lines.

By the biasing of rows and columns (i.e. the upper and lower electrode lines), the cross bar structure can effectively reduce the amount of connections needed to address electrodes from one connection per electrode to a value that is proportional to the square root of the number of electrodes. Thus, an improved scalability and area efficiency may be achieved.

Moreover, having the synthesis wells formed at the crossings between lower electrode lines and upper electrode lines allows the synthesis wells to expose electrode surfaces of the lower and upper electrode lines, without the need for separate electrodes and additional wirings. Hence, a compact and structurally simple synthesis location may be achieved.

Furthermore, the electrode surfaces exposed in each synthesis well may be capacitively coupled to each other to thereby provide the synthesis well with a self-capacitance, thus allowing a charge to be stored at the synthesis well for an amount of time. Thus, a bias across the synthesis well for enabling a synthesis reaction may be maintained after an external biasing voltage via the lower and upper electrode lines has been removed, without the need for e.g. an external capacitor. As will be described in detail below, this enables a time-multiplexed biasing scheme for parallel synthesis in a plurality of synthesis wells.

The arrangement of the synthesis wells at the crossings between the upper and lower electrode lines further allows the electrode surface portions to be arranged in relative proximity to each other (along a vertical direction normal to a main plane of extension of the substrate), compared to a distance to a neighboring synthesis well (along a horizontal direction parallel to the main plane of extension of the substrate). This may reduce the risk of crosstalk between synthesis wells as a result of electric leakage between them, since the path of lowest resistance will be across the biased synthesis well itself.

The well structure of the synthesis locations further provides advantages associated with the synthesis reaction itself. The synthesis wells may define a comparably small partial volume relative the larger common volume of the molecular synthesis array located above the synthesis wells. Thus, the electrically induced reaction conditions for the synthesis reaction may be at least partially confined to each respective synthesis well. This may reduce the risk of cross-talk between neighboring synthesis wells. As a non-limiting and illustrative example, in a synthesis reaction wherein a reaction rate is dependent on the concentration of protons produced from a redox reaction in the reagent solution, a desired concentration of protons may be achieved locally in the partial volume of a selected synthesis well by biasing of the lower and upper electrode lines crossing at the synthesis well. Even if some protons (e.g. driven by the increased concentration of protons) may diffuse out of the selected synthesis well, the proton concentration may drop abruptly in the larger volume outside the synthesis well. Proton out-diffusion from a (selected) synthesis well may hence have a negligible impact on the reaction conditions in neighboring (non-selected) synthesis wells.

Furthermore, during use of the molecular synthesis array, (what may be referred to as) a Schottky-diode-like exponential voltage-dependent current relation can be obtained between the (metal) electrode surface of the lower electrode line in a synthesis well and the reagent solution (e.g. the solution containing the active redox species). This current relation, having an exponential dependence on the applied voltage, may be utilized as a selector device of the molecular synthesis array. Therefore the need for an external transistor-based selector device may be obviated. More precisely, and as may be appreciated by the skilled person, while the current relation is Schottky-diode-like, it is not generated as a result of a metal-semiconductor junction, but rather arises from the non-linear charge transfer resistance between the electrode and the reagent solution arising in redox reactions described by Butler-Volmer kinetics.

Relative spatial terms such as "upper", "lower", "vertical", "arranged on" and "intermediate" may be used herein to refer to locations or directions within a frame of reference of the molecular synthesis array. In particular, these terms may be understood in relation to a bottom-up direction of the molecular synthesis array, i.e. a normal direction to (a main plane of extension) of the substrate. Correspondingly, the term "horizontal" may be understood as locations or orientations transverse to the bottom-up direction, i.e. in relation to / along (the main plane of extension of) the substrate.

The row direction and column direction should be understood as mutually transverse (horizontal) directions, each parallel to the substrate.

By the wording the upper electrode lines "extend across" the lower electrode lines, is hereby meant that the upper electrode lines extend over and past the lower electrode lines. In other words, the upper electrode lines are arranged to define an overlap with the lower electrode lines, as seen along a vertical direction (e.g. towards the substrate). Correspondingly, the wording "at a crossing", as in "at a crossing between a lower electrode line and an upper electrode line", is to be understood as the location where the lower and upper electrode line define an overlap, as seen along a vertical direction (e.g. towards the substrate).

By the wording the upper electrode lines are "vertically separated" from the lower electrode lines, it is hereby meant that the upper and lower electrode lines are separated both physically and galvanically along the vertical direction.

By the wording "embedded", as in the lower and upper electrode lines being "embedded in the insulating layer", it is herein meant that the lower and upper electrode lines are surrounded by the insulating layer.

Each well of the plurality of synthesis wells may comprise an upper portion extending from the upper surface of the insulating layer to the upper electrode line and exposing an upper electrode surface portion of the upper electrode line, and a lower portion extending from the upper electrode line to the electrode surface portion of the lower electrode line.

Providing the synthesis wells with a lower and upper well portion, allows a depth of the synthesis well to be increased without increasing a vertical separation between the lower and upper electrode lines. A deeper synthesis well may contribute to confining the reaction conditions to the selected synthesis well. For example, protons may in use of the synthesis array be generated in the lower portion of a selected synthesis well. Having the upper well portion exposing an upper electrode surface portion of the upper electrode line allows an area of the upper electrode surface portion to be increased relative to an area of the electrode surface portion of the lower electrode line. This may allow balancing a reaction occurring at the lower electrode surface portion at the upper electrode surface portion. Assuming for instance the lower and upper electrode surface portions are configured as a working electrode and a counter electrode, respectively, protons generated by an oxidizing reaction at the working electrode may be consumed in a redox redaction at the counter electrode. This may in turn reduce out-diffusion of protons which may cause crosstalk between synthesis wells.

A cross-sectional area of the upper portion of each well may be larger than a cross-sectional area of the lower portion of the well. More specifically, the exposed upper electrode surface portion of the upper electrode line may be larger than the exposed electrode surface portion of the lower electrode line.

In line with the above discussion, the upper electrode surface portion may thereby enable that protons produced at the lower electrode surface portion of the lower electrode lines are consumed by the upper electrode surface portion of the upper electrode lines to a large extent. Thus, reducing the risk of protons escaping from the synthesis well.

An area of the exposed upper electrode surface portion of the upper electrode line may be at least two times larger than an area of the exposed electrode surface portion of the lower electrode line. The area of the exposed upper electrode surface portion of the upper electrode line may be about three times larger than the area of the exposed electrode surface portion of the lower electrode line.

This may ensure a sufficiently large surface area of the upper electrode surface portion relative the surface area of the lower electrode surface portion.

Each lower electrode line may comprise a selector stack at each synthesis well, the selector stack comprising a lower metal layer, an upper metal layer and an intermediate layer of a semiconductor material or insulating material, wherein the selector stack may form a selector diode and wherein said electrode surface portion of the lower electrode line may be an upper surface portion of the upper metal layer.

In other words, a selector diode may be provided in series to the synthesis well. A selector diode may have a non-linear current response to the potential applied across its terminals. This may be advantageous in that is will ensure a minimum degree of nonlinearity of the resistance across a selected synthesis well, independent of the particular chemical reaction being driven. The selector diode may have a symmetric current-voltage relationship (I-V). This may allow the selector diode to drive reactions requiring either negative or positive potentials. The selector diode may be any two-terminal diode. The selector diode may be a back-to-back Schottky diode. The diode may be a Metal-Semiconductor-Metal (MSM) tunneling diode. The diode may be a Metal-Insulator-Metal (MIM) tunneling diode.

Each electrode surface portion of the lower electrode lines may be configured as a working electrode and each electrode surface portion of the upper electrode lines may be configured as a counter electrode.

Accordingly, in response to a positive (negative) voltage, the working electrode may act as a proton producing (consuming) electrode and the counter electrode may act as a proton consuming (producing) electrode.

A vertical separation between the plurality of lower electrode lines and the plurality of upper electrode lines may be smaller than a spacing of the synthesis wells. In other words, the vertical distance between the upper electrode line and the lower electrode line in a synthesis well may be smaller than a horizontal distance between two neighboring synthesis wells. This enables the preferred path for the current flow to form through the lower electrode line of the selected synthesis well, rather than through neighboring ones.

A vertical separation between the plurality of lower electrode lines and the plurality of upper electrode lines may be 40 to 300 nm, and a spacing of the synthesis wells may be at least two times said vertical separation.

According to a second aspect of the present inventive concept, there is provided a molecular synthesis device. The molecular synthesis device comprises a molecular synthesis array according to the first aspect, and further comprising an array controller configured to enable synthesis in a selected synthesis well among the plurality of synthesis wells of the molecular synthesis array by applying a voltage across the selected synthesis well, via the lower and upper electrode lines crossing at the selected synthesis well. In other words, the array controller may control the voltage of the upper and lower electrode lines to selectively control the molecular synthesis in the different synthesis wells.

The array controller may be further configured to enable synthesis in a set of selected synthesis wells in parallel, by applying a respective train of voltage pulses across each respective synthesis well of the set of synthesis wells, via the lower and upper electrode lines crossing at the respective synthesis well, wherein the array controller may be configured to apply the trains of voltage pulses to the molecular synthesis array simultaneously in a time-division multiplexing fashion. That is, the trains of voltage pulses may be applied in parallel or simultaneously to the synthesis array but with a relative time offset such that any two pulses of any two different trains of voltage pulses do not overlap.

Due to the use of crossbar array structure, for a selective addressing of a single synthesis well, one upper and lower electrode line can be activated at the same time. By use of the time multiplexing schema as described above, a more time effective molecular synthesis process may be performed on the molecular synthesis device. More specifically, since a time of the voltage pulses can be made much shorter than a time of the reaction (e.g. 1 ms vs 10 s) it is possible to multiplex through all the upper and lower electrode lines associated with the set of selected synthesis wells, which may effectively work as if all of the selected synthesis wells were activated at the same time. To facilitate the multiplexing approach, enough charge needs to be stored in a short period of time to allow the reaction to keep taking place while multiplexing through the other electrode lines, which, as discussed above, may be provided by the self-capacitance of the synthesis wells.

The molecular synthesis device may further comprise a cover arranged on the molecular synthesis array and defining a synthesis compartment over the upper surface of the insulating layer for containing a solution comprising synthesis reagents, wherein the synthesis compartment may communicate with the plurality of wells. Accordingly, the synthesis compartment and the synthesis wells of the molecular synthesis device may during use comprise a solution comprising a synthesis reagent.

The molecular synthesis device may further comprise a set of reagent compartments, each configured to contain a reagent solution; an arrangement of fluidic channels coupled between the set of reagent compartments and the synthesis compartment and configured to forward a reagent solution from each reagent compartment to the synthesis compartment; and a fluidic controller configured to control forwarding of the reagent solutions from the reagent compartments to the synthesis compartment.

According to a third aspect of the present inventive concept, there is provided a data storage system. The data storage system comprises a molecular synthesis device according to the second aspect, and a memory controller configured to receive an input data stream to be stored at selected locations in the synthesis array, and to cause the array controller to enable synthesis in the selected synthesis wells based on the input data stream.

According to a fourth aspect of the present inventive concept, there is provided a method for enabling synthesis in a selected synthesis well of a molecular synthesis array of a molecular synthesis device according to the second aspect. The method comprises applying a voltage across the selected synthesis well, via the lower and upper electrode lines crossing at the selected synthesis well.

Effects and features of the second, third and fourth aspects of the present invention are largely analogous to those described above in connection with the first aspect of the inventive concept. Embodiments mentioned in relation to the first aspect of the present invention are largely compatible with the further aspects of the invention. In order to avoid undue repetition, reference is made to the above.

Brief description of the drawings

The above and other aspects of the present inventive concept will now be described in more detail, with reference to appended drawings showing variants of the present inventive concept. The figures should not be considered limiting the invention to the specific variant; instead, they are used for explaining and understanding the inventive concept.

Figure 1 schematically illustrates a molecular synthesis array according to an embodiment.
Figure 2A is a cross-sectional perspective view of a synthesis well of a molecular synthesis array according to one embodiment.

Figure 2B is a cross-sectional perspective view of a synthesis well of a molecular synthesis array according to a further embodiment.

Figure 3A is a schematic circuit layout of a molecular synthesis array comprising synthesis wells of the type depicted in Fig. 2A.

Figure 3B is a schematic circuit layout of a molecular synthesis array comprising synthesis wells of the type depicted in Fig. 2B.

Figure 4 is a schematic view of a molecular synthesis device according to an embodiment.

Figure 5 is a schematic view of a data storage system according to an embodiment.

Figure 6 is a graph for illustrating a write scheme of the molecular synthesis device.

Detailed description

The present inventive concept will now be described more fully hereinafter with reference to the accompanying drawings, in which embodiments are shown. The inventive concept may, however, be implemented in many different forms and should not be construed as limited to the variants set forth herein; rather, these variants are provided for thoroughness and completeness, and fully convey the scope of the present inventive concept to the skilled person.

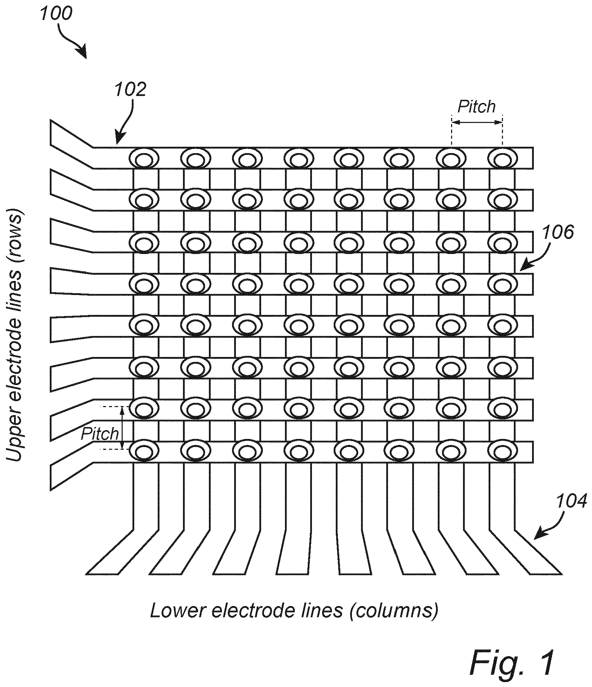

An embodiment of a molecular synthesis array, a molecular synthesis device comprising the molecular synthesis array, a data storage system comprising the molecular synthesis device and method for enabling synthesis in the molecular synthesis device will now be described with reference to Fig. 1 to Fig. 6. It is to be noted that the relative sizes and shapes of the different layers or components may not be representative to a physical realization of the corresponding device. For example, some structures and layers may have been exaggerated herein for illustrative purposes.

The present inventive concept may be used for any application that makes use of in situ DNA synthesis and that requires high density and hence, ultra-high throughput, such as e.g., DNA data storage, gene expression profiling, spatial transcriptomics, etc. Additionally, it may be used to drive other electrochemical reactions as well, not only for DNA synthesis, but also for synthesis of polymers and RNA.

In a data storage application, stable organic molecules (such as polymers, DNA or RNA) may be synthesized in a structured manner to form molecules mapping to data symbols. Being aware of the data encoding scheme employed during writing, i.e. the mapping between data symbols and the building structures of the synthesized molecules, the written data symbols may accordingly be read-out from the structure of the synthesized molecules, e.g. the sequence of monomers (for polymers) or base pairs (for DNA or RNA). In other words, the molecular synthesis array can be used to control the generation of oligonucleotide chains, which can be user to encode data similar to bits.

According to the present inventive concept there is provided a molecular synthesis array comprising an array of synthesis wells defined at crossings between lower and upper electrode lines, each synthesis well defining a respective synthesis location. Reagents for the synthesis may be supplied to the synthesis wells by means of valves and channels, such as microfluidic channels. Subsequently, a synthesizing chemical reaction may be enabled by biasing the electrode surfaces at a selected synthesis well via the respective pair of lower and upper electrode lines crossing at the synthesis well. In the following, reference will mainly be made to solid-phase DNA synthesis controlled through ion generation. It is however envisaged that the molecular synthesis array is compatible also with other synthesis reactions with a reaction rate controllable through an electrochemically induced oxidation-reduction (redox) reaction.-

The in situ synthesis of DNA microarrays is based on conventional solid-phase DNA synthesis. In brief, consecutive synthesis cycles are performed to add phosphoramidites nucleotides to the growing surface-tethered oligonucleotide chain. Each synthesis cycle may consist of the following four steps: phosphoramidite nucleotides coupling, capping, phosphite backbone oxidation and deprotection of the coupled nucleosides to allow the addition of the next phosphoramidite nucleotides. The locally controlled deprotection step (detritylation) enables to add nucleotides at desired positions only and allows therefore for the parallel synthesis of multiple DNA strands.

On electrode arrays, such as the molecular synthesis array of the present invention, the detritylation step may be induced electrochemically. In brief, the synthesis location (i.e. the synthesis well) may be flushed with a detritylation solution containing a redox couple (e.g. hydroquinone/benzoquinone, hydrogen/fluoride, hydrogen/chlorine, or any other redox couple in which the reaction is not limited by diffusion (i.e. a redox reaction dominated by Butler-Volmer kinetics)) known to release protons (e.g. in the form of hydrogen ions, $H^+$) upon oxidation. An oxidation potential with respect to a working electrode and a counter electrode of the synthesis location can be applied where the next nucleotide addition is required. The oxidation reaction occurring at the surface of the selected electrode leads to the release of protons at the electrode surfaces of the synthesis location which results in a localized pH drop which induces the removal of the phosphoramidite's DMT (dimethoxytrityl) protecting group at the surface-tethered oligonucleotide chain. In a subsequent step, the next nucleotide can be added to the chain.

As stated above, the molecular synthesis array utilizes crossing lower and upper electrode lines for selective addressing of synthesis wells in a manner conceptually similar to conventional cross bar addressing schemes. However, selective addressing is not as trivial as for traditional memory chips. The main difference is that in use of the molecular synthesis array, the electrode lines are all in contact with and electrically interconnected to each other through a reagent solution. This makes it more difficult to selectively address the electrodes. However, as realized by the inventors, a Schottky-diode-like exponential voltage-dependent current relation can be obtained (due to the Butler-Volmer kinetics of the redox reaction) between the (metal) electrode surface of the lower electrode line in a synthesis well and the synthesis reagent (e.g. solution containing the active redox species). This mechanism can be utilized as a selector device between individual synthesis locations in order to avoid activating neighboring synthesis wells. Accordingly, the proton generation in a selected synthesis well may be exponentially dependent on to the applied potential. Assuming a linear potential drop across two neighboring synthesis wells (due to their separation), an exponentially lower amount of protons in the neighboring (non-selected) synthesis well can be achieved. Furthermore, as a reaction rate $v$ of the synthesis reaction may be linearly dependent on the powered product of a reactant concentration (e.g. $v = k[H^+]^s[Nucleoside + DMT]^t$, where $[H^+]$ is the proton concentration, and $[Nucleoside + DMT]$ is the concentration of the nucleoside with the DMT protecting group of the phosphoramidite), a reactivity of synthesis wells that has not been selected can be order of magnitudes smaller than that of the selected synthesis location, and thus will require exponentially larger amount of time to yield the same results.

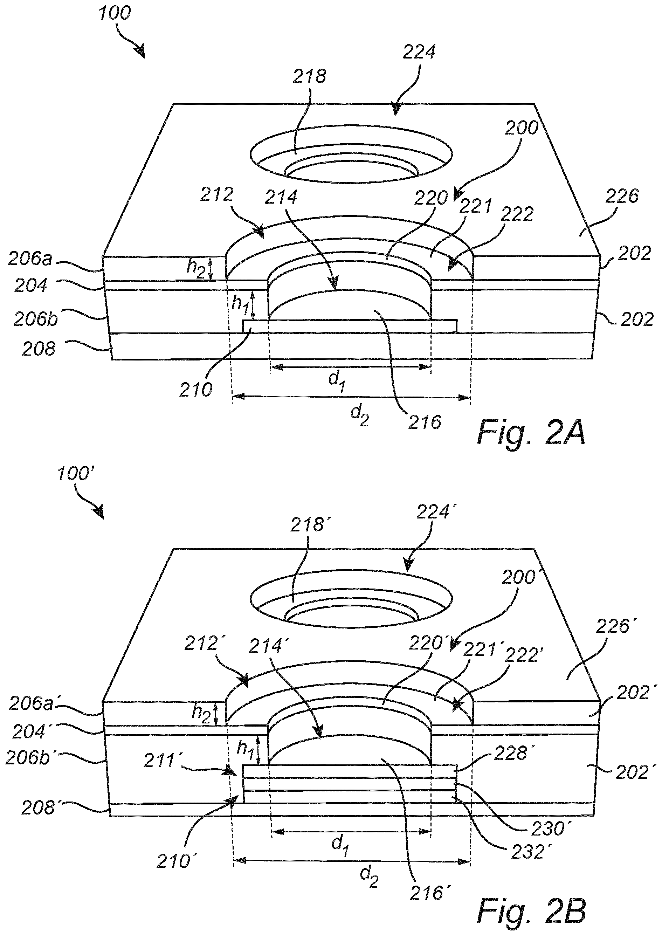

Figure 1 schematically illustrates, by way of example, the molecular synthesis array 100. In particular, Fig. 1 illustrates the general crossbar array structure of the molecular synthesis array 100. Examples of layer structures of the molecular synthesis array 100 is further discussed in connection with Fig. 2A and 2B.

The molecular synthesis array 100 comprises a plurality of lower electrode lines 104. In the present example, the molecular synthesis array 100 comprises eight lower electrode lines. It should however be noted that the molecular synthesis array 100 may comprise any number of lower electrode lines. The plurality of lower electrode lines 104 extends in parallel along a column direction of the molecular synthesis array 100.

The molecular synthesis array 100 further comprises a plurality of upper electrode lines 102. In the present example, the molecular synthesis array 100 comprises eight upper electrode lines. It should however be noted that the molecular synthesis array 100 may comprise any number of upper electrode lines. In the illustrated example, the molecular synthesis array 100 comprises a same number of upper and lower electrode lines. However, the molecular synthesis array 100 may comprise a different number of upper and lower electrode lines. The plurality of upper electrode lines 102 extends in parallel along a row direction of the molecular synthesis array.

The row direction is transverse to the column direction. In the illustrated example, the row direction is perpendicular to the column direction. However, the row direction and the column direction may extend across each other at an angle other than a right angle, such as at a slightly oblique angle. Further, the upper and lower electrode lines 102, 104 are vertically separated from each other, both physically and electrically. Thus, the upper electrode lines extends across the lower electrode lines. It should be noted that even if the upper electrode lines are described as extending in a row direction, while the lower electrode lines are described as extending in a column direction, the opposite can also be possible.

The molecular synthesis array 100 further comprises a plurality of synthesis wells 106. Each synthesis well may function as a synthesis location for the molecular synthesis performed on the molecular synthesis array 100. Each synthesis well (or synthesis location) can function as a bit cell when the molecular synthesis array 100 is used in a data storage system. The plurality of synthesis wells 106 are formed at crossings between a lower electrode line and an upper electrode line. In the molecular synthesis array 100 as illustrated herein, having eight upper and lower electrodes, 64 individual synthesis wells may therefore be formed. In each synthesis well, an electrode surface portion of the upper electrode line and an electrode surface portion of the lower electrode line is exposed to allow a synthesis reaction to be performed. The structure of the synthesis wells are further described below in connection with Fig. 2A and Fig. 2B.

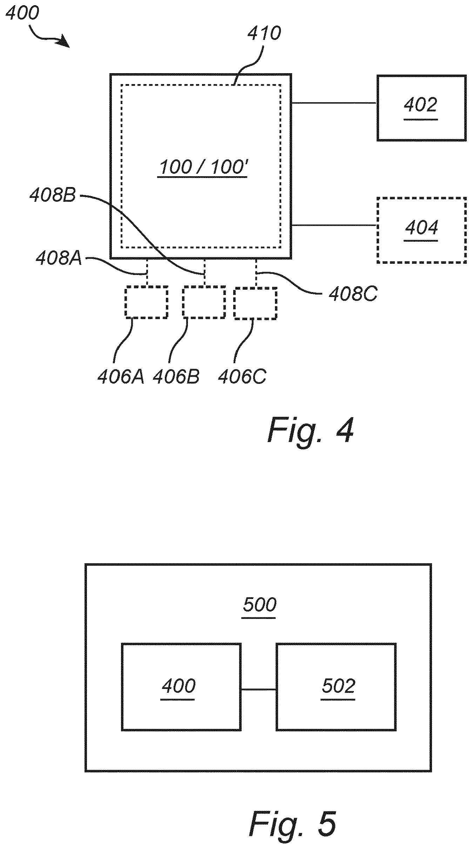

As will be further described in connection with Fig. 4, the upper and lower electrode lines may be connected to an array controller configured to apply voltages to the different electrode lines. A synthesis location (i.e. a synthesis well) can be selected by applying a voltage to the specific upper and lower electrode lines crossing at the synthesis location.

The synthesis wells of the plurality of synthesis wells 106 may be arranged with a regular spacing along the row and column directions, as shown in Fig. 1. A distance between two neighboring synthesis wells along a column direction or a row direction may be referred to as the pitch of the molecular synthesis array. While Fig. 1 indicates that the pitch along the column direction and the pitch along the row direction may be the same, it is envisaged that the array may present different pitches along the column and row directions.

Figure 2A is a perspective view of part of the molecular synthesis array 100. More specifically, Fig. 2A illustrates a synthesis well 200 in cross section, as well as a neighboring synthesis well 224. Synthesis wells 200, 224 are generally representative for any neighboring pair of synthesis wells of the plurality of synthesis wells 106 of the array 100 arranged along a same lower electrode line. In the following, the structure of the synthesis well 200 shown in cross section will be described. It should however be noted that the same structure applies also to the other synthesis wells of the molecular synthesis array 100.

As described above in connection with Fig. 1, the molecular synthesis array 100 comprises a plurality of lower electrode lines 104 and a plurality of upper electrode lines 102. The upper and lower electrode lines may be formed by any material suitable as an electrode material. Examples include, but are not limited to, platinum, gold and ruthenium.

In the part of the molecular synthesis array 100 illustrated in Fig. 2A, reference sign 210 and reference sign 204 indicate the respective pair of lower and upper electrode lines crossing at the synthesis well 200. The lower electrode line 210 extends in a column direction (i.e. upwards and into the image plane). The upper electrode line 204 extends in a row direction (i.e. from side to side as seen from the image plane). An upper electrode line 218 crossing the lower electrode line 210 at the neighboring synthesis well 224 is also shown, extending in parallel with the upper electrode line 204 .

As seen in Fig. 2A, the molecular synthesis array 100 further comprises a substrate 208. The molecular synthesis array 100 further comprises an insulating layer 202 arranged on the substrate 208. The insulating layer 202 may comprise one or more insulating materials. For example, the insulating layer 202 may comprise one or more layers of silicon oxides and/or silicon nitrides. The upper and lower electrode lines 204, 210 are embedded in the insulating layer 202. In particular, the upper and lower electrode lines 204, 210 may be entirely encapsulated by the insulating layer 202, except for the portions exposed in the synthesis well 200. The upper and lower electrode lines 204, 210 are vertically separated from each other. A portion 206b of the insulating layer 202 is thus arranged between the upper and lower electrode lines 204, 210, to separate them from each other. The insulating layer 202 further comprise an upper portion 206a arranged on and covering the upper electrode line 204. The upper portion 206a of the insulating layer 202 has a thickness denoted by $h_2$. The thickness may be 40 to 300 nm. The lower electrode line 210 may be arranged directly on a (non-conductive) surface portion of the substrate 208. However, the lower electrode line 210 may also be arranged within the insulating layer 202, to be surrounded by the insulating layer from all sides.

The synthesis well 200 is formed at a crossing between the upper and lower electrode lines 204, 210. The synthesis well 200 extends from an upper surface 226 of the insulating layer 202 to the lower electrode line 210. Thus, the synthesis well 200 extends through the insulating layer 202 and through the upper electrode line 204. The synthesis well 200 thereby exposes an electrode surface portion 222 of the upper electrode line 204 and an electrode surface portion 216 of the lower electrode line 210. The electrode surface portion 216 of the lower electrode line 210 may form a bottom surface of the synthesis well 200. The exposed electrode surface portions 222, 216 of the upper and lower electrode lines 204, 210 may thus serve as the electrode surfaces for the synthesis well 200. In particular, the electrode surface portion 216 of the lower electrode line 210 may be configured as a working electrode of the synthesis well 200. The electrode surface portion 222 of the upper electrode line 204 may be configured as a counter electrode of the synthesis well 200.

The synthesis well 200 is herein illustrated as circular well. However, as the skilled person realizes, the synthesis well 200 may have other shapes as well, such as polygonal or elliptical.

The synthesis well 200 may as shown comprise an upper portion 212 and an lower portion 214. The upper portion 212 and the lower portion 214 of the synthesis well 200 may be centered in relation to a common central axis as seen along a vertical direction (e.g. towards the substrate). The upper portion 212 extends from the upper surface 226 of the insulating layer 202 to the upper electrode line 204 to expose an upper electrode surface portion 221 of the upper electrode line 204. The lower portion 214 of the synthesis well 200 extends from and through the upper electrode line 204 to the electrode surface portion 216 of the lower electrode line 210. As is seen in Fig. 1, the upper electrode surface portion 221 circumferentially encloses a top-most part of the lower portion 214 of the synthesis well 200 formed through the upper electrode line 204 (i.e. the hole in the upper electrode line 204).

The lower portion 214 of the synthesis well 200 has a first diameter, as indicated by the label $d_1$. The upper portion 212 of the synthesis well 200 has a second diameter, as indicated by the label $d_2$. As may be seen in Fig. 1, $d_2$ is greater than $d_1$, so that a cross-sectional area of the upper portion 212 (as seen along the vertical direction) exceeds a cross-sectional area of the lower portion 214. In particular, an area $A_2$ of the exposed upper electrode surface portion 221 of the upper electrode line 204 may be larger than an area $A_1$ of the exposed electrode surface portion 216 of the lower electrode line 210..

Determining the dimensions of the synthesis array 100 is a tradeoff between (1) ensuring that the area $A_2$ is large enough (in relation to the area $A_1$) to benefit the synthesis reaction and reduce the risk of cross-talk and (2) keeping the area $A_2$ small enough to also allow a small pitch of the synthesis array 100 (and thus a high density synthesis array).

The diameters of the upper and lower portion 212, 214 of the synthesis well 200, $d_1$ and $d_2$, and the pitch $p$ may be determined as follows.

The area $A_1$ of the exposed electrode surface portion 216 of the lower electrode line 210 can be expressed as:

$$A_1 = \pi r_1{}^2,$$

where $r_1$ is the radius of the lower portion 214 of the synthesis well 200. Consequently, the area $A_2$ of the exposed upper electrode surface portion 221 of the upper electrode line 204 (neglecting a side surface portion 220 of the upper electrode line 204) can be expressed as:

$$A_2 = \pi r_2{}^2 - \pi r_1{}^2,$$

where $r_2$ is the radius of the upper portion 212 of the synthesis well 200. A relation between $A_2$ and $A_1$ can be formulated as:

$$A_2 = \alpha A_1,$$

where $\alpha$ is a proportionally factor. Preferably, $A_2$ is equal to or larger than $A_1$ (i.e. $\alpha \geq 1$). More preferably, $A_2$ is larger than $A_1$ (i.e. $\alpha > 1$). Even more preferably, $A_2$ is at least two times larger than $A_1$ ($\alpha \geq 2$).

Given the expressions of $A_1$ and $A_2$ above, the relation between $A_2$ and $A_1$ can be rewritten as:

$$\pi r_2{}^2 - \pi r_1{}^2 = \alpha \pi r_1{}^2$$

$$r_2{}^2 = (1 + \alpha)r_1{}^2$$

$$r_2 = \sqrt{(1 + \alpha)r_1{}^2} = \sqrt{(1 + \alpha)}\, r_1$$

$$d_2 = \sqrt{(1 + \alpha)d_1{}^2} = \sqrt{(1 + \alpha)}\, d_1.$$

As an example, given that the diameter of the lower portion 214 of the synthesis well 200 is selected as 20 nm (i.e. $d_1 = 20\ nm$) and that the area $A_1$ of the exposed electrode surface portion 216 of the lower electrode line 210 should be two times larger than the area $A_2$ of the exposed upper electrode surface portion 221 of the upper electrode line 204 (i.e. $\alpha = 2$), the diameter of the upper portion 212 of the synthesis well 200 will be 34.64 nm (i.e. $d_2 = 34.64\ nm$). As a non-limiting example, $d_1$ may be 20 nm or larger, and $d_2$ may be 35 nm or larger. The pitch $p$ may be 80 nm or larger.

The smallest pitch $p_{min}$ possible may be expressed as

$$p_{min} = d_2 + CD,$$

where $CD$ is the critical dimension for the electrode line spacing (e.g. along the row or column direction) for the technology node of the fabrication process used for patterning the electrode lines. The critical dimension may typically be the same as the diameter of the lower portion 214 of the synthesis well 200. Having a critical dimension $CD$ of e.g. 20 nm, will thus result in a smallest pitch $p_{min}$ of 54.64 nm in the example above.

As an alternative to upper and lower well portions 212, 214 of different diameters, it is contemplated that a width of the synthesis well 200 may be the same along the depth dimension the synthesis well 200. In such case, the electrode surface portion 222 of the upper electrode line 204 may be the side surface portion 220 of the upper electrode line 204 enclosing the opening through the upper electrode line.

In any case, the vertical separation between the lower electrode line 210 and the upper electrode line 204 may be smaller than a spacing between the synthesis well 200 and the neighboring synthesis well 224 (i.e. the pitch of the molecular synthesis array 100), as this improves the selectivity of the addressing scheme.

Given a distance $h_1$ (see Fig. 2A) between the lower and upper electrode surface portions 216, 221 in the synthesis well 200, a depth $h_2$ of the upper portion 212 of the synthesis well 200 (i.e. a distance between the upper surface 226 of the insulating layer 202 and the upper electrode surface portion 221, see Fig. 2A), and a pitch $p$ of the synthesis well 200, the distance $D$ between the upper electrode surface portion 221 of a selected synthesis well 200 to the lower electrode surface portion of a neighboring non-selected synthesis well 224 along a same lower electrode line 210 (i.e. a same column) is given by (neglecting a thickness of the upper electrode line 204 ):

$$D = h_1 + 2h_2 + p$$

Accordingly, $D$ will exceed $h_1$ by an amount set dependent on the values of $h_2\, p$. Thus, the preferential path for the current flow in the reagent solution will be through the selected synthesis well 200, and not through the neighbouring synthesis well 224 (e.g. assuming the conductivity of the reagent solution within the lower well portion 214 of the synthesis well 200 is not orders of magnitude lower than in the upper well portion 212 and outside the synthesis well 200). As a non-limiting example, with $h_1$ and $h_2$ being 300 nm, and $p$ being 3000 nm, $D = 3900 = 13h_1$. More generally, $h_1$ may be 40 to 300 nm, $h_2$ may be 40 to 300 nm, and $p$ may be at least two times $h_1$.

As may be appreciated, the actual resistance value will depend on the composition of the reagent solution used, or more specifically, on the ionic conductivity of the reagent solution. The ionic conductivity of the reagent solution depends on an ion concentration (e.g. salt content) of the reagent solution. The higher the salt content, the higher the conductivity. In practice, the ion concentration of the reagent solution should be chosen such that a resistance between the lower electrode surface portion 216 and the upper electrode surface portion 221 of a selected synthesis well is in the order of an electron tunneling resistance (i.e. charge transfer resistance) between the electrode surfaces and the reagent solution.

Given a certain value on the distance $h_2$, the distance $h_1$ may be chosen as any value up to a maximum value given by:

$$h_{1(\max)} = \frac{(p + 2h_2)}{2}.$$

Table 1 shows different values of $d_2$, p and $h_1$ for a number of examples of $d_1$, and assuming $\alpha = 2$ and $h_2 = 100$.

*Table 1*

| CD (=$d_1$) (nm) | $\alpha$ | $d_2$ (nm) | Pitch (nm) | $h_2$ (nm) | $h_{1(max)}$ (nm) |
|---|---|---|---|---|---|
| 20 | 2 | 34.6 | 54.6 | 100 | 127.3 |
| 40 | 2 | 69.3 | 109.3 | 100 | 154.6 |
| 48 | 2 | 83.1 | 131.1 | 100 | 165.6 |
| 64 | 2 | 110.9 | 174.9 | 100 | 187.4 |
| 80 | 2 | 138.6 | 218.6 | 100 | 209.3 |
| 10 | 2 | 17.3 | 27.3 | 100 | 113.7 |
| 140 | 2 | 242.5 | 382.5 | 100 | 291.2 |
| 200 | 2 | 346.4 | 546.4 | 100 | 373.2 |
| 250 | 2 | 433.0 | 683.0 | 100 | 441.5 |
| 350 | 2 | 606.2 | 956.2 | 100 | 578.1 |
| 800 | 2 | 1385.6 | 2185.6 | 100 | 1192.8 |
| 1000 | 2 | 1732.1 | 2732.1 | 100 | 1466.0 |
| 3000 | 2 | 5196.2 | 8196.2 | 100 | 4198.1 |

Table 2 shows different values of $d_2$, p and $h_1$ for a number of examples of $d_1$, and assuming $\alpha = 1$ and $h_2 = 100$.

*Table 2*

| CD (=$d_1$) (nm) | $\alpha$ | $d_2$ (nm) | Pitch (nm) | $h_2$ (nm) | $h_{1(max)}$ (nm) |
|---|---|---|---|---|---|
| 20 | 1 | 28.3 | 48.3 | 100 | 124.1 |
| 40 | 1 | 56.6 | 96.6 | 100 | 148.3 |
| 48 | 1 | 67.9 | 115.9 | 100 | 157.9 |
| 64 | 1 | 90.5 | 154.5 | 100 | 177.3 |
| 80 | 1 | 113.1 | 193.1 | 100 | 196.6 |
| 10 | 1 | 14.1 | 24.1 | 100 | 112.1 |
| 140 | 1 | 198.0 | 338.0 | 100 | 269.0 |
| 200 | 1 | 282.8 | 482.9 | 100 | 341.4 |
| 250 | 1 | 353.6 | 603.6 | 100 | 401.8 |
| 350 | 1 | 495.0 | 845.0 | 100 | 522.5 |
| 800 | 1 | 1131.4 | 1931.4 | 100 | 1065.7 |
| 1000 | 1 | 1414.2 | 2414.2 | 100 | 1307.1 |

(continued)

| CD (=$d_1$) (nm) | $\alpha$ | $d_2$ (nm) | Pitch (nm) | $h_2$ (nm) | $h_{1(max)}$ (nm) |
|---|---|---|---|---|---|
| 3000 | 1 | 4242.6 | 7242.6 | 100 | 3721.3 |

Figure 2B is a perspective view of part of a molecular synthesis array 100' comprising synthesis wells according to a further embodiment. More specifically, Fig. 2B illustrates in cross section one such synthesis well 200'. Reference sign 224' represents a neighboring synthesis well along a same column. Synthesis wells 200', 224' are generally representative for any neighboring pair of synthesis wells of the array 100' arranged along a same lower electrode line. In the following, the structure of the synthesis well 200' shown in cross section will be described. It should however be noted that the same structure applies also to the other synthesis wells of the molecular synthesis array 100'.

As the molecular synthesis array 100' of Fig. 2B shares many features with the molecular synthesis array 100 of Fig. 2A, reference is made to the above to avoid undue repetition. Instead, the following discussion focuses on what differs from the structure of Fig. 2B. In Fig. 2B, the reference numerals are suffixed with a tilde (') and unless stated otherwise correspond to the similarly numbered features in Fig. 2A.

The lower electrode line 210' of the synthesis well 200' comprises a selector stack 211' at a position below the synthesis well 200'. The selector stack 211' comprises a lower metal layer 232', an upper metal layer 228' and an intermediate layer 230'. As illustrated herein, the intermediate layer 230' is arranged between the lower metal layer 232' and the upper metal layer 228'. The intermediate layer 230' may be formed by a semiconductor material or an insulating material, or a stack of different semiconductor or insulating materials. Examples of semiconductor materials include, but are not limited to, aSi, Si, IGZO and two dimensional materials such as $MoS_2$, $MoSe_2$ and $WSe_2$. The selector stack 211' may form a selector diode of the synthesis well 200'. The selector diode 211' may thus function as a selector for the synthesis well 200', thereby improving selectivity of the molecular synthesis array 100. In the case of a selector stack, an upper surface portion of the upper metal layer 228' may form the electrode surface portion 216' of the lower electrode line 210' at the synthesis well 200'. while the lower metal layer 232' may form the lower electrode line extending along the column direction.

The selector stacks along each lower electrode line 210' may be formed as a respective layer stack on a continuous metal line. Put differently, the lower electrode line 210' may be formed by the lower metal layer 232' being a continuous line along the entire column. At each crossing between the lower electrode line 210' and the upper electrode lines 204', a layer stack of the intermediate layer 230' and the upper metal layer 228' may be formed on top of the (continuous) electrode line 210'. In other words, the selector stacks may be formed as islands along a continuous metal line. Alternatively, all layers of the selector stack may be continuous lines. Put differently, the selector stack may be formed by continuous lines of the lower metal layer 232' , intermediate layer 230' and upper metal layer 228' extending along the entire column.

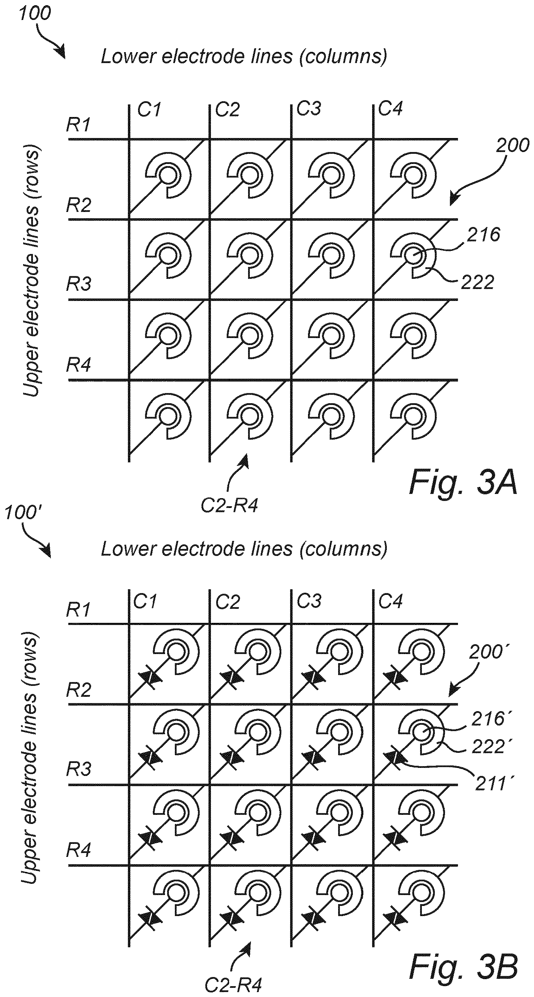

Figure 3A illustrates, by way of example, a circuit layout of the molecular synthesis array 100 in a schematic view. The circuit layout of Fig. 3A corresponds to the example of the molecular synthesis array 100 having synthesis wells 200 as described above in connection with Fig. 2A.

For illustrative purposes the molecular synthesis array 100 is herein illustrated as having four lower electrode lines, C1 to C4, and four upper electrode lines, R1 to R4. For each pair of lower and upper electrode lines, a synthesis well 200 is provided, resulting in 16 synthesis wells. Each synthesis well has an electrode surface portion 216 of a lower electrode line and an electrode surface portion 222 of an upper electrode line as described above. To clearly illustrate the electrical connections of the molecular synthesis array 100, the synthesis wells are illustrated to the side of the crossing points between the upper and lower electrode lines. It should however be noted that the synthesis wells as described above are formed at the crossing points between the upper and lower electrode lines. As stated above, the electrode surface portion 216 of the lower electrode line may serve as a working electrode, and the electrode surface portion 222 of the upper electrode line may serve as a counter electrode.

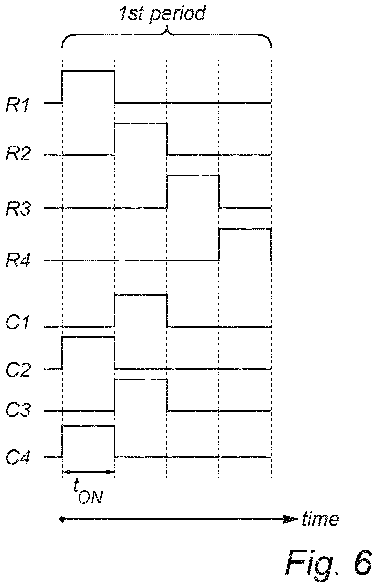

As an example, the synthesis well at the crossing C2-R4 may be activated by applying a voltage to the second lower electrode line C2 and the fourth upper electrode line R4. A way of controlling the individual synthesis wells will be described below in connection with Fig. 6.

Figure 3B illustrates, by way of example, a circuit layout of the molecular synthesis array 100' in a schematic view. The circuit layout of Fig. 3B corresponds to the example of the molecular synthesis array 100' having synthesis wells 200' as described above in connection with Fig. 2B.

As in Fig. 3A, the molecular synthesis array 100' is herein illustrated as having four lower electrode lines, C1 to C4, four upper electrode lines, R1 to R4, and 16 synthesis wells.

As opposed to the molecular synthesis array 100 of Fig. 3A, the molecular synthesis array 100' of Fig. 3B further comprises a selector stack/ diode 211'. The selector diode 211' is connected in series between the lower electrode line (e.g. C1-C4) and the electrode surface portion 216' of the lower electrode line.

In this molecular synthesis array 100, the non-linearity of the electrochemical reaction itself (e.g. due to the Butler-Volmer kinetics of the reaction), in addition to the selector diode 211' acts as the selector for each synthesis well. Since the selector diode 211' introduces a non-linearity, the selectivity between the synthesis wells is to a lesser degree dependent on the non-linearity of the electro-chemical reduction itself..

Figure 4 is a schematic view of a molecular synthesis device 400. The molecular synthesis device 400 comprising a molecular synthesis array 100 or 100' of any one of the embodiments described in connection with Fig. 1 to 3B. The molecular synthesis device 400 further comprises an array controller 402. The array controller 402 is configured to enable synthesis in a selected synthesis well among the plurality of synthesis wells of the molecular synthesis array 100. The array controller 402 may enable the synthesis by applying a voltage across the selected synthesis well, via the lower and upper electrode lines crossing at the selected synthesis well. For the purpose of providing voltages and currents to the electrode lines, the array controller 402 may comprise driver circuitry including column line drivers and row line drivers. The function and implementation of such driver circuitry is per se known to the skilled person and will therefore not be further described herein.

The array controller 402 may be further configured to enable synthesis in a set of selected synthesis wells in parallel. The parallel synthesis may be performed by applying a respective train of voltage pulses across each respective synthesis well of the set of selected synthesis wells, via the lower and upper electrode lines crossing at the respective synthesis wells, wherein the trains of voltage pulses are applied to the molecular synthesis array 100 simultaneously in a time-division multiplexing fashion. An example of how the synthesis can be performed in the time-division multiplexing fashion is further described in connection with Fig. 6 below.

The molecular synthesis device 400 may further comprise a cover arranged on the molecular synthesis array 100 to define a synthesis compartment or fluid cell 410 over the upper surface of the insulating layer for receiving and containing a solution comprising synthesis reagents (i.e. a reagent solution). The synthesis compartment 410 may communicate with the plurality of synthesis wells. Accordingly, a solution received in the synthesis compartment 410 may flow into and fill the synthesis wells.

The molecular synthesis device 400 may further comprise a set of reagent compartments 406A-C. Each reagent compartment of the set of reagent compartments 406A-C may be configured to contain a reagent solution. The different reagent compartments of the set of reagent compartments 406A-C may contain different reagent solutions, e.g. reagent compartments comprising solutions with different phosphoramidites nucleotides, and a reagent compartment comprising a detritylation solution comprising a redox couple (e.g. to facilitate proton release in selected synthesis wells and thus enable a synthesis reaction therein).

The molecular synthesis device 400 may further comprise an arrangement of fluidic channels 408A-C coupled between the set of reagent compartments 406A-C and the synthesis compartment 410 and configured to forward a reagent solution from each reagent compartment to the synthesis compartment 410. The fluidic channels may for example be microfluidic channels. Additional fluidic channels may be present for managing the flow of reagent solution within the molecular synthesis device 400.

The molecular synthesis device 400 may further comprise a fluidic controller 404. The fluidic controller 404 may be configured to control forwarding of the reagent solutions from the reagent compartments 406A-C to the synthesis compartment 410. The fluidic controller 404 may e.g. be a microfluidic controller. The fluidic controller 404 may control the flow of the reagent solutions using techniques which per se are known in the art, for instance by controlling valves arranged along the fluidic channels 408A-C.

The molecular synthesis device 400 may be configured to enable synthesis of oligonucleotides tethered to the lower electrode surface portions of the synthesis wells of the synthesis array 100, 100' using solid-phase DNA synthesis, wherein the molecular synthesis device 400 may be configured to enable synthesis in a selected synthesis well (or a set of selected synthesis wells using time division multiplexing) by applying a voltage across the selected synthesis well, via the lower and upper electrode lines crossing at the selected synthesis well, to cause deprotection of a protected nucleoside of an oligonucleotide chain tethered to the lower electrode surface of the selected synthesis well. A nucleotide in the reagent solution may thereby be added to the oligonucleotide chain. As described above, the applied voltage may induce an oxidation reaction of a redox couple in the reagent solution such that protons may be released at the electrode surface and enable the deprotection (e.g. removal of the protecting group from the oligonucleotide chain). This process may be repeated to sequentially add nucleotides to the oligonucleotide chain. The type of nucleotide added may be varied by changing between reagent solutions comprising the desired type of nucleotide, e.g. adenine, cytosine, thymine or guanine (A, C, T, G).

In addition to inducing deprotection to enable addition of a nucleotide to the oligonucleotide chain through proton generation, which implies a voltage of positive polarity across the lower electrode surface portion (working electrode) and the upper electrode surface portion (counter electrode) of a selected synthesis well, a negative polarity voltage may be applied to enable a grafting process. Grafting refers to the process of functionalizing the working electrode for the synthesis, i.e. attaching one or more anchoring molecules (such as diazonium compound) to the lower electrode surface portion on which a (respective) oligonucleotide chain can be synthesized. Grafting may, like nucleotide-addition, be selectively enabled by applying a voltage of a negative polarity across the lower electrode surface portion and the upper electrode surface portion of a selected synthesis well. It is however contemplated that grafting alternatively may be enabled non-selectively, i.e. in all synthesis wells of the synthesis array as an initialization step preceding (selective) sequential oligonucleotide in the synthesis wells. As may be appreciated, the magnitudes of the positive polarity voltage (for deprotection) and the negative polarity voltage (for grafting) may be different.

Figure 5 is a schematic view of a data storage system 500. The data storage system 500 comprises a molecular synthesis device 400, e.g. as described above in connection with Fig. 4. The data storage system 500 further comprises a memory controller 502. The memory controller 502 is configured to receive an input data stream to be stored at selected locations in the molecular synthesis array of the molecular synthesis device 400. The memory controller 502 may be configured to cause the fluidic controller 404 to supply the appropriate reagents solution to the synthesis array 100, 100', responsive to the input data stream. The memory controller 502 may further be configured to cause the array controller of the molecular synthesis device 400 to enable synthesis in the selected synthesis wells based on the input data stream. Thus, the data storage system 500 may allow for storing data in the molecular synthesis device 400 by molecular synthesis.

The memory controller 502 may be configured to map a received data symbol of the input data stream to a respective nucleotide or a respective sequence of nucleotides. For example, using four nucleotides A, C, T and G data symbols may be stored in a base 4 system. In other words, the memory controller 502 may translate data symbols of the input data stream from a binary format to a "polymer" domain wherein the input data stream is expressed as a sequence of polymers. The memory controller 502 may thereafter synthesize the sequence of polymers in in one or more selected synthesis wells.

Figure 6 is a graph illustrating a scheme for enabling synthesis in one or more selected synthesis wells of the molecular synthesis device, such as the molecular synthesis device 400 as described above in connection with Fig. 4.

In the simplest case, where only a single synthesis well is to be addressed (i.e. having data written to it), a single activation pulse of sufficient length to complete the reaction can be applied to the corresponding upper and lower electrode lines. When activating a synthesis well, the activation pulses (i.e. voltage pulses) are such that either a positive or negative bias is applied across that synthesis well, depending on what reaction is to be performed (e.g. deprotection or grafting). Thus, the polarity of the activation pulses applied to the lower and upper electrode lines of the selected synthesis well may be either a positive or negative potential. Upper and/or lower electrode lines coupled to non-selected synthesis wells may be left floating (e.g. disconnected from the driving from the driving circuitry of the array controller). With reference to Fig. 3A or 3B, the synthesis well at the crossing between R1-C2 may be enabled by applying activation pulses to the respective electrode lines R1 and C2 simultaneously, as seen in Fig. 6. The magnitude of the voltage applied across the selected synthesis cell should exceed an overpotential of the redox reaction. In Fig. 3A, the overpotential may depend on the exponential voltage-dependent current relation due to the Butler-Volmer kinetics of the redox reaction. In Fig. 3B, the overpotential may depend on a combination of the exponential voltage-dependent current relation due to the Butler-Volmer kinetics of the redox reaction and threshold voltage of the selector diode 211'.

As further indicated in Fig. 6, it is possible to simultaneously enable synthesis in further synthesis wells arranged along a same upper electrode line, e.g. in the synthesis well at the crossing between R1-C4 by simultaneously applying an activation pulse along C4. More specifically, synthesis reactions may be enabled in a set of synthesis wells in parallel by applying trains of activation/voltage pulses to the synthesis array in a time division multiplexing fashion. Such an approach will now be described with reference to Fig. 6 and an example where synthesis is to be enabled in synthesis wells at the crossings between R1-C2, R1-C4, R2-C1 and R2-C3 (as seen in Fig. 3A and 3B) simultaneously. Fig. 6 illustrates a first period of a number of trains of pulses. Each train of pulses is applied to a respective upper or lower electrode line. As mentioned above, the pulses represent the activation of the individual upper and lower electrode lines, rather than an actual potential being applied (which depends on the type of reaction). The respective "activation pulses" applied to the rows R1-R4 and the columns C1-C4 may hence be referred to as row address strobes and column address strobes, respectively. A length of time of the first period may correspond to a time which the self-capacitance of each synthesis well is able to hold enough charge to allow the synthesis reaction to continue to be performed, even though no external bias is applied. The first period of train of activation pulses may be repeated until the synthesis reaction in the synthesis wells is finished.

The first period is split into four time segments. Each time segments corresponds to a pulse length of each pulse, denoted by $t_{ON}$.

In the first time segment, an activation pulse is applied to the first upper electrode line R1. In addition, activation pulses are applied to the second and fourth lower electrode lines, C2 and C4. Thus, synthesis wells R1-C2 and R1-C4 are activated for a time period of $t_{ON}$, after which, the first upper electrode line R1, as well as the second and fourth lower electrode lines, C2 and C4, are deactivated for the rest of the first period.

In the second time segment an activation pulse is applied to the second upper electrode line R2. In addition, activation pulses are applied to the first and third lower electrode lines, C1 and C3. Thus, synthesis wells R2-C1 and R2-C3 are activated for a time period of $t_{ON,}$, after which they are deactivated.

In the third and fourth time segments, activation pulses are applied to the third and fourth upper electrode lines respectively. However, since no lower electrode line is activated, these trains of pulses do not result in any activated synthesis well. To achieve a more effective addressing scheme, synthesis wells at which no activation is to take place can be skipped.

As stated above, the period of train pulses illustrated herein may be repeated, such that in a subsequent time segment, the synthesis wells R1-C2 and R1-C4 are again activated, and so on.

By this example, it has been illustrated how multiple synthesis wells can be activated simultaneously, by applying trains of activation pulses. By reducing the pulse length, $t_{ON}$, more synthesis wells may be simultaneously enabled.

**Claims**

1. A molecular synthesis array (100, 100') comprising:

   a substrate (208, 208');
   an insulating layer (202, 202') arranged on the substrate (208, 208');
   a plurality of lower electrode lines (104) extending in parallel along a column direction of the molecular synthesis array (100, 100'), and a plurality of upper electrode lines (102) extending in parallel along a row direction of the molecular synthesis array (100, 100'), wherein the upper electrode lines (102) are vertically separated from the lower electrode lines (104) and extend across the lower electrode lines (104), and wherein the lower and upper electrode lines (104, 102) are embedded in the insulating layer (202, 202'); and
   a plurality of synthesis wells (106), wherein each well (200, 200') is formed at a crossing between a lower electrode line (210, 210') and an upper electrode line (204, 204') and extends from an upper surface (226) of the insulating layer (202, 202') to the lower electrode line (210, 210'), through the insulating layer (202, 202') and through the upper electrode line (204, 204'), and exposes an electrode surface portion (222, 222') of the upper electrode line (204, 204') and an electrode surface portion (216, 216') of the lower electrode line (210, 210').

2. The molecular synthesis array (100, 100') according to claim 1, wherein each well (200, 200') of the plurality of synthesis wells (106) comprises an upper portion (212, 212') extending from the upper surface (226, 226') of the insulating layer (202, 202') to the upper electrode line (204, 204') and exposing an upper electrode surface portion (221, 221') of the upper electrode line (204, 204'), and a lower portion (214, 214') extending from the upper electrode line (204, 204') to the electrode surface portion (216, 216') of the lower electrode line (210, 210').

3. The molecular synthesis array (100, 100') according to claim 2, wherein a cross-sectional area of the upper portion (212, 212') of each well is larger than a cross-sectional area of the lower portion (214, 214') of the well.

4. The molecular synthesis array (100, 100') according to claim 2 or 3, wherein an area of the exposed upper electrode surface portion (221, 221') of the upper electrode line (204, 204') is at least two times larger than an area of the exposed electrode surface portion (216, 216') of the lower electrode line (210, 210').

5. The molecular synthesis array (100') according to any one of the preceding claims, wherein each lower electrode line (210') comprises a selector stack at each synthesis well (200') , the selector stack comprising a lower metal layer (232'), an upper metal layer (228') and an intermediate layer (230') of a semiconductor material or insulating material, wherein the selector stack forms a selector diode (211') and wherein said electrode surface portion (216') of the lower electrode line (210') is an upper surface portion of the upper metal layer (228').

6. The molecular synthesis array (100, 100') according to any one of the preceding claims, wherein each electrode surface portion (216, 216') of the lower electrode lines (104) is configured as a working electrode and each electrode surface portion (222, 222') of the upper electrode lines (102) is configured as a counter electrode.

7. The molecular synthesis array (100, 100') according to any one of the preceding claims, wherein a vertical separation between the plurality of lower electrode lines (104) and the plurality of upper electrode lines (102) is smaller than a spacing of the synthesis wells (106).

8. The molecular synthesis array (100, 100') according to any one of the preceding claims, wherein a vertical separation between the plurality of lower electrode lines (104) and the plurality of upper electrode lines (102) is 40 to 300 nm, and a spacing of the synthesis wells (106) is at least two times said vertical separation.

9. The molecular synthesis array (100, 100') according to any one of the preceding claims, wherein the plurality of lower electrode lines (104) and the plurality of upper electrode lines (102) are formed by Ruthenium.

10. A molecular synthesis device (400) comprising a molecular synthesis array (100, 100') according to any one of the preceding claims, and further comprising an array controller (402) configured to enable synthesis in a selected synthesis well among the plurality of synthesis wells of the molecular synthesis array (100, 100') by applying a voltage across the selected synthesis well, via the lower and upper electrode lines crossing at the selected synthesis well.

11. The molecular synthesis device (400) according to claim 10, wherein the array controller (402) is further configured to enable synthesis in a set of selected synthesis wells in parallel, by applying a respective train of voltage pulses across each respective synthesis well of the set of synthesis wells, via the lower and upper electrode lines crossing at the respective synthesis well, wherein the array controller (402) is configured to apply the trains of voltage pulses to the molecular synthesis array simultaneously in a time-division multiplexing fashion.

12. The molecular synthesis device (400) according to claim 10 or 11, further comprising a cover arranged on the molecular synthesis array and defining a synthesis compartment (410) over the upper surface of the insulating layer for containing a solution comprising synthesis reagents, wherein the synthesis compartment (410) communicates with the plurality of wells.

13. The molecular synthesis device (400) according to claim 12, further comprising:

a set of reagent compartments (406A-C), each configured to contain a reagent solution;
an arrangement of fluidic channels (408A-C) coupled between the set of reagent compartments (406A-C) and the synthesis compartment (410) and configured to forward a reagent solution from each reagent compartment (406A-C) to the synthesis compartment (410); and
a fluidic controller (404) configured to control forwarding of the reagent solutions from the reagent compartments (406A-C) to the synthesis compartment (410).

14. A data storage system (500) comprising a molecular synthesis device (400) according to any of the claims 10 to 13, and a memory controller (502) configured to receive an input data stream to be stored at selected locations in the synthesis array, and to cause the array controller to enable synthesis in the selected synthesis wells based on the input data stream.

15. A method for enabling synthesis in a selected synthesis well of a molecular synthesis array (100, 100') of a molecular synthesis device (400) according to any of the claims 10 to 13, the method comprising applying a voltage across the selected synthesis well, via the lower and upper electrode lines crossing at the selected synthesis well.

**Patentansprüche**

1. Molekularsyntheseanordnung (100, 100') umfassend:

ein Substrat (208, 208');
eine Isolierschicht (202, 202'), die auf dem Substrat (208, 208') angeordnet ist;
eine Vielzahl von unteren Elektrodenleitungen (104), die sich parallel entlang einer Spaltenrichtung der Molekularsyntheseanordnung (100, 100') erstrecken, und eine Vielzahl von oberen Elektrodenleitungen (102), die sich parallel entlang einer Zeilenrichtung der Molekularsyntheseanordnung (100, 100') erstrecken, wobei die oberen Elektrodenleitungen (102) von den unteren Elektrodenleitungen (104) senkrecht getrennt sind und sich quer über die unteren Elektrodenleitungen (104) erstrecken, und wobei die unteren und oberen Elektrodenleitungen (104, 102) in die Isolierschicht (202, 202') eingebettet sind; und
eine Vielzahl von Synthesemulden (106), wobei jede Mulde (200, 200') an einer Kreuzung zwischen einer unteren Elektrodenleitung (210, 210') und einer oberen Elektrodenleitung (204, 204') gebildet ist und sich von einer oberen Oberfläche (226) der Isolierschicht (202, 202') zu der unteren Elektrodenleitung (210, 210') durch die Isolierschicht (202, 202') und durch die obere Elektrodenleitung (204, 204') hindurch erstreckt und einen Elektrodenoberflächenabschnitt (222, 222') der oberen Elektrodenleitung (204, 204') und einen Elektrodenoberflächenabschnitt (216, 216') der unteren Elektrodenleitung (210, 210') freilegt.

2. Molekularsyntheseanordnung (100, 100') nach Anspruch 1, wobei jede Mulde (200, 200') der Vielzahl von Synthesemulden (106) einen oberen Abschnitt (212, 212'), der sich von der oberen Oberfläche (226, 226') der Isolierschicht (202, 202') zu der oberen Elektrodenleitung (204, 204') erstreckt und einen oberen Elektrodenoberflächenabschnitt (221, 221') der oberen Elektrodenleitung (204, 204') freilegt, und einen unteren Abschnitt (214, 214'), der sich von der oberen Elektrodenleitung (204, 204') zu dem Elektrodenoberflächenabschnitt (216, 216') der unteren Elektrodenleitung (210, 210') erstreckt, umfasst.

3. Molekularsyntheseanordnung (100, 100') nach Anspruch 2, wobei eine Querschnittsfläche des oberen Abschnitts (212, 212') jeder Mulde größer als eine Querschnittsfläche des unteren Abschnitts (214, 214') der Mulde ist.

4. Molekularsyntheseanordnung (100, 100') nach Anspruch 2 oder 3, wobei eine Fläche des freigelegten oberen Elektrodenoberflächenabschnitts (221, 221') der oberen Elektrodenleitung (204, 204') mindestens zweimal größer als eine Fläche des freigelegten Elektrodenoberflächenabschnitts (216, 216') der unteren Elektrodenleitung (210, 210') ist.

5. Molekularsyntheseanordnung (100') nach einem der vorhergehenden Ansprüche, wobei jede untere Elektrodenleitung (210') einen Selektorstapel an jeder Synthesemulde (200') umfasst, wobei der Selektorstapel eine untere Metallschicht (232'), eine obere Metallschicht (228') und eine Zwischenschicht (230') aus einem Halbleitermaterial oder einem Isoliermaterial umfasst, wobei der Selektorstapel eine Selektordiode (211') bildet, und wobei der Elektrodenoberflächenabschnitt (216') der unteren Elektrodenleitung (210') ein oberer Oberflächenabschnitt der oberen Metallschicht (228') ist.

6. Molekularsyntheseanordnung (100, 100') nach einem der vorhergehenden Ansprüche, wobei jeder Elektrodenoberflächenabschnitt (216, 216') der unteren Elektrodenleitungen (104) als Arbeitselektrode konfiguriert ist, und jeder Elektrodenoberflächenabschnitt (222, 222') der oberen Elektrodenleitungen (102) als Gegenelektrode konfiguriert ist.

7. Molekularsyntheseanordnung (100, 100') nach einem der vorhergehenden Ansprüche, wobei eine senkrechte Trennung zwischen der Vielzahl von unteren Elektrodenleitungen (104) und der Vielzahl von oberen Elektrodenleitungen (102) kleiner als ein Zwischenraum der Synthesemulden (106) ist.

8. Molekularsyntheseanordnung (100, 100') nach einem der vorhergehenden Ansprüche, wobei eine senkrechte Trennung zwischen der Vielzahl von unteren Elektrodenleitungen (104) und der Vielzahl von oberen Elektrodenleitungen (102) 40 bis 300 nm beträgt, und ein Zwischenraum der Synthesemulden (106) mindestens zweimal die senkrechte Trennung ist.

9. Molekularsyntheseanordnung (100, 100') nach einem der vorhergehenden Ansprüche, wobei die Vielzahl von unteren Elektrodenleitungen (104) und die Vielzahl von oberen Elektrodenleitungen (102) aus Ruthenium gebildet sind.

10. Molekularsynthesevorrichtung (400), umfassend eine Molekularsyntheseanordnung (100, 100') nach einem der vorhergehenden Ansprüche, und ferner umfassend eine Anordnungssteuervorrichtung (402), die dazu konfiguriert ist, eine Synthese in einer ausgewählten Synthesemulde aus der Vielzahl von Synthesemulden der Molekularsyntheseanordnung (100, 100') durch Anlegen einer Spannung über die ausgewählte Synthesemulde anhand der unteren und oberen Elektrodenleitungen, die sich an der ausgewählten Synthesemulde kreuzen, zu ermöglichen.

11. Molekularsynthesevorrichtung (400) nach Anspruch 10, wobei die Anordnungssteuervorrichtung (402) ferner dazu konfiguriert ist, eine parallele Synthese in einem Satz von ausgewählten Synthesemulden durch Anlegen einer jeweiligen Folge von Spannungsimpulsen über jede jeweilige Synthesemulde des Satzes von Synthesemulden anhand der unteren und oberen Elektrodenleitungen, die sich an der jeweiligen Synthesemulde kreuzen, zu ermöglichen, wobei die Anordnungssteuervorrichtung (402) dazu konfiguriert ist, die Folgen von Spannungsimpulsen an die Molekularsyntheseanordnung nach Zeitmultiplexart gleichzeitig anzulegen.

12. Molekularsynthesevorrichtung (400) nach Anspruch 10 oder 11, ferner umfassend eine Abdeckung, die auf der Molekularsyntheseanordnung angeordnet ist und ein Synthesekompartiment (410) über der oberen Oberfläche der Isolierschicht definiert, um eine Lösung zu enthalten, die Synthesereagenzien umfasst, wobei das Synthesekompartiment (410) mit der Vielzahl von Mulden in Verbindung steht.

13. Molekularsynthesevorrichtung (400) nach Anspruch 12, ferner umfassend:

einen Satz von Reagenzkompartimenten (406A-C), die jeweils dazu konfiguriert sind, eine Reagenzlösung zu enthalten;

eine Anordnung von fluidischen Kanälen (408A-C), die zwischen dem Satz von Reagenzkompartimenten (406A-C) und dem Synthesekompartiment (410) gekoppelt sind und dazu konfiguriert sind, eine Reagenzlösung von jedem Reagenzkompartiment (406A-C) an das Synthesekompartiment (410) weiterzugeben; und

eine fluidische Steuervorrichtung (404), die dazu konfiguriert ist, die Weitergabe der Reagenzlösungen von den Reagenzkompartimenten (406A-C) an das Synthesekompartiment (410) zu steuern.

14. Datenspeichersystem (500), umfassend eine Molekularsynthesevorrichtung (400) nach einem der Ansprüche 10 bis 13, und eine Speichersteuervorrichtung (502), die dazu konfiguriert ist, einen Eingangsdatenstrom zu empfangen, der an ausgewählten Stellen in der Syntheseanordnung zu speichern ist, und zu bewirken, dass die Anordnungssteuervorrichtung eine Synthese in den ausgewählten Synthesemulden basierend auf dem Eingangsdatenstrom ermöglicht.

15. Verfahren zum Ermöglichen einer Synthese in einer ausgewählten Synthesemulde einer Molekularsyntheseanordnung (100, 100') einer Molekularsynthesevorrichtung (400) nach einem der Ansprüche 10 bis 13, wobei das Verfahren das Anlegen einer Spannung über die ausgewählte Synthesemulde anhand der unteren und oberen Elektrodenleitungen, die sich an der ausgewählten Synthesemulde kreuzen, umfasst.

## Revendications

1. Réseau de synthèse moléculaire (100, 100') comprenant :

   un substrat (208, 208') ;
   une couche isolante (202, 202') disposée sur le substrat (208, 208') ;
   une pluralité de lignes d'électrodes inférieures (104) s'étendant en parallèle le long d'une direction de colonne du réseau de synthèse moléculaire (100, 100'), et une pluralité de lignes d'électrodes supérieures (102) s'étendant en parallèle le long d'une direction de rangée du réseau de synthèse moléculaire (100, 100'), dans lequel les lignes d'électrodes supérieures (102) sont séparées verticalement des lignes d'électrodes inférieures (104) et s'étendent à travers les lignes d'électrodes inférieures (104), et dans lequel les lignes d'électrodes inférieures et supérieures (104, 102) sont intégrées dans la couche isolante (202, 202') ; et
   une pluralité de puits de synthèse (106), dans lequel chaque puits (200, 200') est formé à un croisement entre une ligne d'électrode inférieure (210, 210') et une ligne d'électrode supérieure (204, 204') et s'étend d'une surface supérieure (226) de la couche isolante (202, 202') à la ligne d'électrode inférieure (210, 210'), à travers la couche isolante (202, 202') et à travers la ligne d'électrode supérieure (204, 204'), et expose une partie de surface d'électrode (222, 222') de la ligne d'électrode supérieure (204, 204') et une partie de surface d'électrode (216, 216') de la ligne d'électrode inférieure (210, 210').

2. Réseau de synthèse moléculaire (100, 100') selon la revendication 1, dans lequel chaque puits (200, 200') de la pluralité de puits de synthèse (106) comprend une partie supérieure (212, 212') s'étendant de la surface supérieure (226, 226') de la couche isolante (202, 202') à la ligne d'électrode supérieure (204, 204') et exposant une partie de surface d'électrode supérieure (221, 221') de la ligne d'électrode supérieure (204, 204'), et une partie inférieure (214, 214') s'étendant de la ligne d'électrode supérieure (204, 204') à la partie de surface d'électrode (216, 216') de la ligne d'électrode inférieure (210, 210').

3. Réseau de synthèse moléculaire (100, 100') selon la revendication 2, dans lequel une surface transversale de la partie supérieure (212, 212') de chaque puits est plus grande qu'une surface transversale de la partie inférieure (214, 214') du puits.

4. Réseau de synthèse moléculaire (100, 100') selon la revendication 2 ou 3, dans lequel un périmètre de la partie de surface d'électrode supérieure exposée (221, 221') de la ligne d'électrode supérieure (204, 204') est au moins deux fois plus grande qu'un périmètre de la partie de surface d'électrode exposée (216, 216') de la ligne d'électrode inférieure (210, 210').

5. Réseau de synthèse moléculaire (100') selon une quelconque des revendications précédentes, dans lequel chaque ligne d'électrode inférieure (210') comprend une pile de sélecteurs au niveau de chaque puits de synthèse (200'), la pile de sélecteurs comprenant une couche métallique inférieure (232'), une couche métallique supérieure (228') et une couche intermédiaire (230') d'un matériau semi-conducteur ou d'un matériau isolant, dans lequel la pile de sélecteurs forme une diode de sélecteur (211') et dans lequel ladite partie de surface d'électrode (216') de la ligne d'électrode inférieure (210') est une partie de surface supérieure de la couche métallique supérieure (228').

6. Réseau de synthèse moléculaire (100, 100') selon une quelconque des revendications précédentes, dans lequel chaque partie de surface d'électrode (216, 216') des lignes d'électrodes inférieures (104) est configurée comme une électrode de travail et chaque partie de surface d'électrode (222, 222') des lignes d'électrodes supérieures (102) est configurée comme une contre-électrode.

7. Réseau de synthèse moléculaire (100, 100') selon une quelconque des revendications précédentes, dans lequel une séparation verticale entre la pluralité de lignes d'électrodes inférieures (104) et la pluralité de lignes d'électrodes supérieures (102) est inférieure à un espacement des puits de synthèse (106).

8. Réseau de synthèse moléculaire (100, 100') selon une quelconque des revendications précédentes, dans lequel une séparation verticale entre la pluralité de lignes d'électrodes inférieures (104) et la pluralité de lignes d'électrodes supérieures (102) est de 40 à 300 nm, et un espacement des puits de synthèse (106) est au moins deux fois ladite séparation verticale.

9. Réseau de synthèse moléculaire (100, 100') selon une quelconque des revendications précédentes, dans lequel la pluralité de lignes d'électrodes inférieures (104) et la pluralité de lignes d'électrodes supérieures (102) sont formées par du ruthénium.

10. Dispositif de synthèse moléculaire (400) comprenant un réseau de synthèse moléculaire (100, 100') selon une quelconque des revendications précédentes, et comprenant en outre un contrôleur de réseau (402) configuré pour permettre la synthèse dans un puits de synthèse sélectionné parmi la pluralité de puits de synthèse du réseau de synthèse moléculaire (100, 100') en appliquant une tension aux bornes du puits de synthèse sélectionné, via les lignes d'électrode inférieure et supérieure se croisant au niveau du puits de synthèse sélectionné.

11. Dispositif de synthèse moléculaire (400) selon la revendication 10, dans lequel le contrôleur de réseau (402) est en outre configuré pour permettre la synthèse dans un ensemble de puits de synthèse sélectionnés en parallèle, en appliquant un train respectif d'impulsions de tension aux bornes de chaque puits de synthèse respectif de l'ensemble de puits de synthèse, via les lignes d'électrode inférieure et supérieure se croisant au niveau du puits de synthèse respectif, dans lequel le contrôleur de réseau (402) est configuré pour appliquer les trains d'impulsions de tension au réseau de synthèse moléculaire simultanément selon un mode de multiplexage à répartition temporelle.

12. Dispositif de synthèse moléculaire (400) selon la revendication 10 ou 11, comprenant en outre un couvercle disposé sur le réseau de synthèse moléculaire et définissant un compartiment de synthèse (410) sur la surface supérieure de la couche isolante pour contenir une solution comprenant des réactifs de synthèse, dans lequel le compartiment de synthèse (410) communique avec la pluralité de puits.

13. Dispositif de synthèse moléculaire (400) selon la revendication 12,
comprenant en outre :

   un ensemble de compartiments de réactifs (406A-C), chacun configuré pour contenir une solution réactive ;
   un agencement de canaux fluidiques (408A-C) couplés entre l'ensemble de compartiments de réactif (406A-C) et le compartiment de synthèse (410) et configurés pour transférer une solution réactive de chaque compartiment de réactif (406A-C) vers le compartiment de synthèse (410) ; et
   un contrôleur fluidique (404) configuré pour contrôler le transfert des solutions réactives des compartiments de réactif (406A-C) vers le compartiment de synthèse (410).

14. Système de mémorisation de données (500) comprenant un dispositif de synthèse moléculaire (400) selon une quelconque des revendications 10 à 13 et un contrôleur de mémoire (502) configuré pour recevoir un flux de données d'entrée à mémoriser à des emplacements sélectionnés dans le réseau de synthèse et pour amener le contrôleur de réseau à permettre la synthèse dans les puits de synthèse sélectionnés sur la base du flux de données d'entrée.

15. Procédé permettant de réaliser une synthèse dans un puits de synthèse sélectionné d'un réseau de synthèse moléculaire (100, 100') d'un dispositif de synthèse moléculaire (400) selon une quelconque des revendications 10 à 13, le procédé comprenant l'application d'une tension aux bornes du puits de synthèse sélectionné, via les lignes d'électrodes inférieure et supérieure se croisant au niveau du puits de synthèse sélectionné.

Lower electrode lines (columns)

Fig. 1

Fig. 2A

Fig. 2B

*Fig. 3A*

*Fig. 3B*

400

410

100 / 100'

402

404

408B

408A

408C

406A 406B 406C

*Fig. 4*

500

400

502

*Fig. 5*

Fig. 6

**EP 4 286 041 B1**

**Patent documents cited in the description**

- WO 2020131354 A